(19) **Europäisches Patentamt / European Patent Office / Office européen des brevets**

(11) **EP 3 455 639 B1**

(12) **EUROPEAN PATENT SPECIFICATION**

(45) Date of publication and mention
of the grant of the patent:
**01.06.2022 Bulletin 2022/22**

(21) Application number: **16731998.7**

(22) Date of filing: **13.05.2016**

(51) International Patent Classification (IPC):
**G01R 29/08** (2006.01)     **G01R 31/00** (2006.01)

(52) Cooperative Patent Classification (CPC):
**G01R 29/0814; G01R 31/001; G01R 31/007**

(86) International application number:
**PCT/JP2016/064951**

(87) International publication number:
**WO 2017/195379 (16.11.2017 Gazette 2017/46)**

(54) **ELECTROMAGNETIC NOISE PATH DETECTING SYSTEM, ROLLING STOCK WITH AN ELECTROMAGNETIC NOISE PATH DETECTING SYSTEM, AND METHOD TO DETERMINE AN ELECTROMAGNETIC NOISE PATH**

SYSTEM ZUR ERKENNUNG EINES ELEKTROMAGNETISCHEN RAUSCHPFADES, SCHIENENFAHRZEUGE MIT SYSTEM ZUR ERKENNUNG EINES ELEKTROMAGNETISCHEN RAUSCHPFADES UND VERFAHREN ZUR BESTIMMUNG EINES ELEKTROMAGNETISCHEN RAUSCHPFADES

SYSTÈME DE DÉTECTION DE TRAJET DE BRUIT ÉLECTROMAGNÉTIQUE, MATÉRIEL ROULANT AVEC SYSTÈME DE DÉTECTION DE TRAJET DE BRUIT ÉLECTROMAGNÉTIQUE, ET PROCÉDÉ DE DÉTECTION D'UN TRAJET DE BRUIT ÉLECTROMAGNÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**20.03.2019 Bulletin 2019/12**

(73) Proprietor: **Hitachi, Ltd.**
**Tokyo 100-8280 (JP)**

(72) Inventor: **PAOLETTI Umberto**
**Tokyo 100-8280 (JP)**

(74) Representative: **Mewburn Ellis LLP**
**Aurora Building**
**Counterslip**
**Bristol BS1 6BX (GB)**

(56) References cited:
**US-A1- 2010 237 693**    **US-A1- 2011 001 633**
**US-A1- 2011 135 027**    **US-A1- 2015 028 888**

- **MENG JIN ET AL: "Identification of Essential Coupling Path Models for Conducted EMI Prediction in Switching Power Converters", IEEE TRANSACTIONS ON POWER ELECTRONICS, INSTITUTE OF ELECTRICAL AND ELECTRONICS ENGINEERS, USA, vol. 21, no. 6, 1 November 2006 (2006-11-01), pages 1795-1803, XP011142837, ISSN: 0885-8993, DOI: 10.1109/TPEL.2006.882905**
- **JONGKWANG LIM: "Control practice of electromagnetic environmental effects (E3) for hybrid electric vehicles", 2015 IEEE 2ND INTERNATIONAL FUTURE ENERGY ELECTRONICS CONFERENCE (IFEEC), IEEE, 1 November 2015 (2015-11-01), pages 1-5, XP032834942, DOI: 10.1109/IFEEC.2015.7361399 ISBN: 978-1-4799-7655-3 [retrieved on 2015-12-18]**

EP 3 455 639 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

[TECHNICAL FIELD]

The present invention relates to a measurement system and a method to individuate causes of electromagnetic compatibility (EMC) problems of electronic equipment.

[BACKGROUND OF THE INVENTION]

Electric current and charges in electronic equipment generate electromagnetic (EM) fields that can cause troubles to the electronic equipment itself or to other electronic equipment. In order to design EMC countermeasures, it is very important to identify the sources of EM emissions and the related emission path of the EM noise.

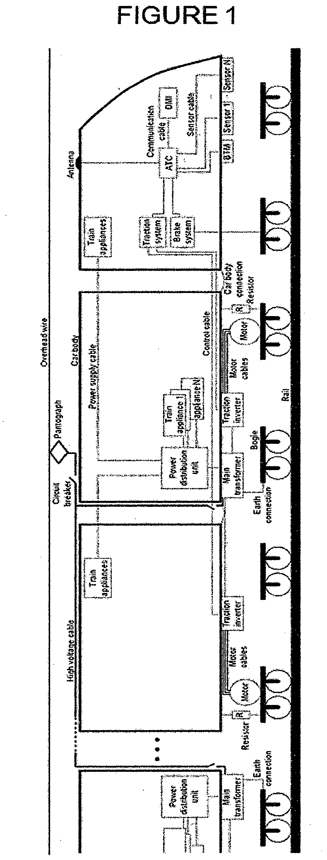

Fig. 1 shows a railway rolling stock as an example of electrical system which generates EM field. In the railway rolling stock shown in Fig. 1, examples of possible noise victims are the automatic train control (ATC), sensors, antennas including the balise transmission module (BTM) and any train appliance in general, such as light, air conditioning, and others. Examples of possible noise sources are the traction inverter, the pantograph, the circuit breakers and the overhead wires. Examples of paths could be any cable connected to this equipment.

[CITATION LIST]

[Patent Literature]

Patent Literature 1 : Japanese Laid Open Patent H06-288873

Patent Literature 2 : US 2015/0028888 proposes a system for identifying an electrical noise propagation path.

Patent Literature 3 : US 2011/0135027 proposes a chaotic wide band frequency modulator.

Non Patent Literature

Non Patent Literature 1 : J.J.-C. Bolomey and F.E. Gardiol: "Engineering Applications of the Modulated Scatterer technique," Artech House, 2001, chapters 2.1, 2.2, 3.4.

Non Patent Literature 2 : R.-R. Lao, et al: "High-Sensitivity Optically Modulated Scatterer for Electromagnetic-Field Measurement," IEEE Transactions On Instrumentation and Measurement, vol. 56, no. 2, pp. 486-490, Apr. 2007.

[SUMMARY OF INVENTION]

[Technical Problem]

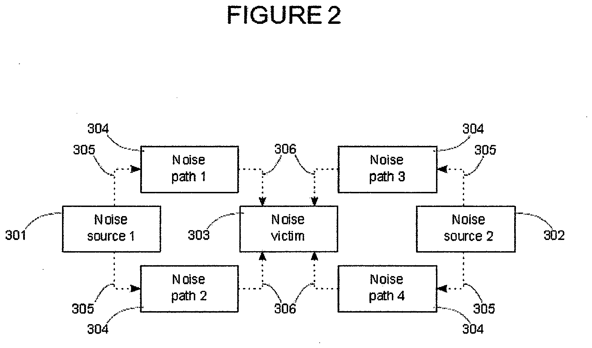

Fig. 2 shows a common situation when dealing with EMC problems diagrammatically. At first a malfunction is detected in an electronic equipment which is call noise victim 303. In many cases the actual noise source is not known and possible noise sources exist, such as the noise sources 301 and 302. Even when the actual noise source is known, often several possible paths 304 exist from the noise source 302 to the victim 303.

Patent Literature 1 discloses a technology which can detect a fault location in an automobile, but it cannot identify the sources of EM emissions and the related emission path of the EM noise.

For the railway rolling stock shown in Fig. 1, further difficulties are due to the large dimensions and to the fact that the rolling stock is moving, changing therefore the environment conditions and reducing the reproducibility of EMC problems. In this circumstance, the inventor made the following considerations

In order to determine the noise path, the electric or the magnetic fields are measured in several locations of the possible noise paths directly or in the form of their related quantities, the voltage and the electric current. When large values of the electric or magnetic fields are found, these locations are suspected of belonging to the noise path with a higher probability. However, higher values of the field might indicate that a connection 305 between a noise source and a possible noise path exists, but it cannot confirm the connection 306 between the possible noise path and the victim.

More sophisticated techniques try to calculate the correlation between the measured noise at the victim 303 and the measured EM field on the suspected noise path 304 using more complex measurement techniques and equipment. However, a high correlation might occur also in the case that two possible noise paths have the same noise source that causes the trouble to the victim, even if only one is connected to the victim through the connection 306. Therefore, even if in this case the probability of finding the noise path increases, the noise path cannot be ultimately confirmed.

What is done in practice to finally confirm the noise path is to modify the suspected noise path by means of a filter, an EM shield, a switch, a change of position or similar, and by checking the effect on the victim. If the noise in the victim is also modified, then at least one of the dominant noise paths can be confirmed.

One problem with above method is the time required to conduct at least these two steps: first to measure the EM field and second to modify the suspected noise path for confirmation. In the embodiments of the present invention, the noise path is detected in a single measurement by applying a known time variation to the noise, which will be called modulation in the following, and by checking the presence of the applied time variation in the noise victim.

Another problem with the above technique is due to the cables that are generally used to measure the EM field because they can affect the measurement results and cannot be easily wired through closed enclosures. Furthermore, for equipment of large size, such as rolling stock, the cable length imposes practical limitations to the measurements and complicates the overall setup.

This invention provides a measurement system according to claim 1 and a method according to claim 10 to detect the electromagnetic noise path precisely and efficiently.

[Solution to Problem]

An aspect of the present invention is an electromagnetic noise path detecting system. This system comprising a noise modulator and a processing system. The noise modulator is strongly enough coupled to a suspected noise path that it applies a modulation to an electromagnetic noise when present. The processing system determines an amount of said modulation on the electromagnetic noise and identifies whether the suspected noise path is an actual noise path or not.

Another aspect of the present invention is a rolling stock with an electromagnetic noise path detecting system. The noise path detecting system comprising a noise modulator and a processing system. The noise modulator is strongly enough coupled to a suspected noise path that it applies a modulation to an electromagnetic noise when present. The processing system determines an amount of said modulation on the electromagnetic noise and identify whether the suspected noise path is an actual noise path or not. The noise modulator is applied to one or a plurality of the following cables and connecting elements as said suspected noise path;

a cables between a main transformer and a power distribution unit,

a connecting element between consecutive car bodies,

a cable between a power distribution unit and a train appliance,

a cable among train appliances,

a cable inside a power distribution unit.

Another aspect of the present invention is a method to determine an electromagnetic noise path after an electromagnetic noise has been detected at a noise victim and one or a plurality of suspected noise paths have been selected. This method includes 3 steps.

first step; a modulation is applied the said suspected noise path,

second step; an attempt to detect said modulation at the location of said noise victim is made,

third step; depending on an amount of a detected modulation, it is decided whether the suspect noise path has been confirmed or not.

[Advantageous Effects of Invention]

The present invention provides a measurement system and a method to detect the electromagnetic noise path precisely and efficiently.

[BRIEF DESCRIPTION OF DRAWINGS]

Fig. 1: Schematic representation of electrical system of railway rolling stock.

Fig. 2: Problem description.

Fig. 3: Working principle of the present invention.

Fig. 4: An embodiment of the invention: noise source modulation technique.

Fig. 5: An embodiment of the invention: magnetic probe with modulated load for the NSMT.

Fig. 6: Noise modulator and processing system.

Fig. 7: Block model of noise modulator.

Fig. 8: Example of modulated load impedance magnitude.

Fig. 9: Simple example of noise waveform after modulation.

Fig. 10: Block diagram of processing system.

Fig. 11: Processing algorithm.

Fig. 12: FFT of received noise amplitude.

Fig. 13: Noise source modulator system comprising receiving system.

Fig. 14: Block model of main functions of receiving system.

Fig. 15: Block model of main functions of receiving system with filter and down converter.

Fig. 16: Noise modulator system with multiple modulators.

Fig. 17: Noise modulator system with multiple modulators and receiving system.

Fig. 18: Method to detect the noise path.

Fig. 19: Modulator on cable between main transformer and power distribution unit.

Fig. 20: Modulator on connections between car bodies.

Fig. 21: Modulator between power distribution unit and train appliance.

Fig. 22: Modulator between train appliances.

Fig. 23: Modulator on power distribution unit.

[DESCRIPTION OF EMBODIMENTS]

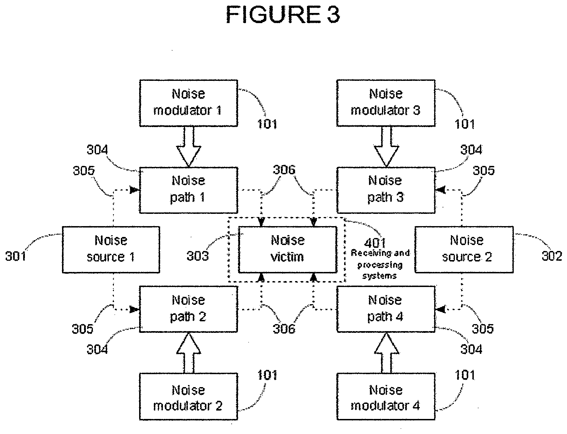

Fig. 3 shows the working principle behind the present embodiments. One noise modulator 101 applies a known modulation to one of the noise paths 304, and its effect is observed at the noise victim 303 with the help of a receiving system and a processing system 401. Different modulations can be applied to each noise path 304 in order to conduct simultaneously the analysis on multiple noise paths. Based on the amount of noise modulation at the victim 303, the noise path can be determined.

In order to detect the noise path 304, the following embodiments comprise a noise modulator 101 and a receiving and processing systems 401. The noise modulator 101 applies a modulation to the suspected noise path 304. The processing system processes the noise received by the receiving system and evaluates the amount of noise modulation. The method to detect the electromagnetic noise path comprises a comparison of the amount of noise modulation at the receiver with and without using the modulator to determine whether the modulation is affecting or not the received noise. When the received noise is affected by the modulation, the noise path has been confirmed.

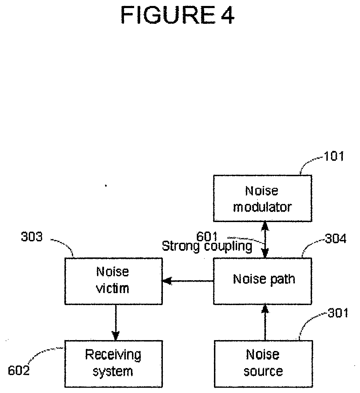

Fig. 4 shows a block diagram of the measurement setup for the embodiments of the present invention (noise source modulation technique or NSMT). An unknown EM noise is generated by a noise source 301 and after propagating through an unknown noise path 304 it is detected by the receiving system 602 connected to the noise victim 303. The suspected noise path 304 can include a radiated portion and a conducted portion, and the target of the measurement is to confirm whether the suspected noise path is one of the dominant noise paths or not. In order to do this, a modulation is applied to the suspected noise path by a noise modulator 101 which has a strong coupling 601 with the noise path 304. When a modulation frequency much smaller than the noise frequency is used, after being modulated the noise follows the same path as the original non-modulated noise.

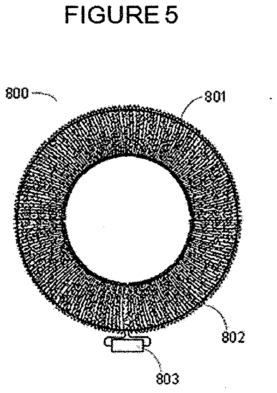

Fig. 5 shows an example of a magnetic probe 800 with a modulated load 803 for using the noise modulator 101. Magnetic probe 800 also includes a coil 801 and a magnetic core 802 in the coil. The magnetic probe 800 must be sufficiently coupled to the suspected noise path 304 in order to apply a modulation to the noise, and it should be weakly coupled to the noise victim 303 in order for the noise not to follow a different path than the original one.

For example, when the suspected noise path 304 is an electrically-conductive cable, the cable penetrates the center of the coil 801 for strong coupling with the cable. On the other hand, the modulator should be located distant from the noise victim. Because the electromagnetic coupling between the noise modulator and the noise victim should be low enough that a radiated noise by the noise modulator cannot be detected at said noise victim.

[Embodiment 1]

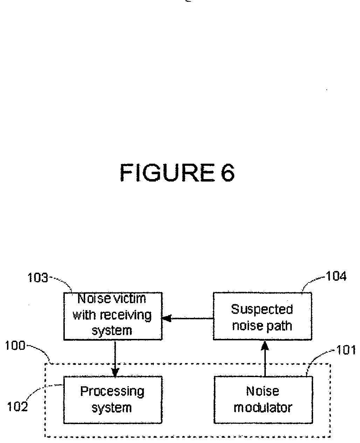

Fig. 6 shows a measurement system 100 of an embodiment and comprises a noise modulator 101 and a processing system 102. The noise modulator applies a modulation to the suspected noise path 104, that is a known time variation to the noise when it is present. The processing system 102 processes the noise received by the noise victim's receiving system 103.

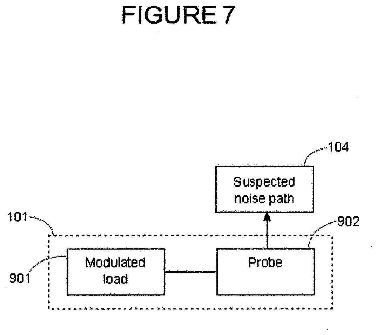

Fig. 7 shows a block model of a simple realization of the noise modulator 101. Noise modulator 101 comprises a probe 902 connected to a modulated load 901. The modulated load 901 has an impedance value that changes with time. A representation of magnetic probe 902 (800) with a modulated load 901 (803) was shown in Fig. 5.

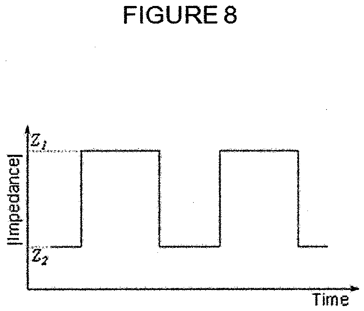

Fig. 8 is an example of impedance value variation with time. Possible realizations of the modulated load 901 are described for example in the non-patent Literatures 1 and 2 and can be an electronically, optically, or mechanically varying load. The probe 902 must provide a strong coupling to the noise path in order for the modulator to be effective. For example, in the case that the noise path is the common mode current on a cable, a possible realization is the noise modulator 800 comprising a loaded current probe shown in Fig. 5, which comprises a coil 801 around a magnetic core 802 and connected to a modulated load 803.

In order to better clarify the effect of the noise modulator 101, a simple example comprising of a noise harmonic of frequency f0 can be considered. After modulation, the noise will comprise of the combination of the noise harmonic at the original frequency plus other multiple harmonics of the modulating frequency $\Delta f$. By considering only the first harmonic at each side of the noise harmonic, the modulated noise can be represented with equation (1).

$$y_N = A_0 \cos\left(2\pi f_0 t\right) + A_1 \cos\left[2\pi\left(f_0 + \Delta f\right)t\right] - A_1 \cos\left[2\pi\left(f_0 - \Delta f\right)t\right] \tag{1}$$

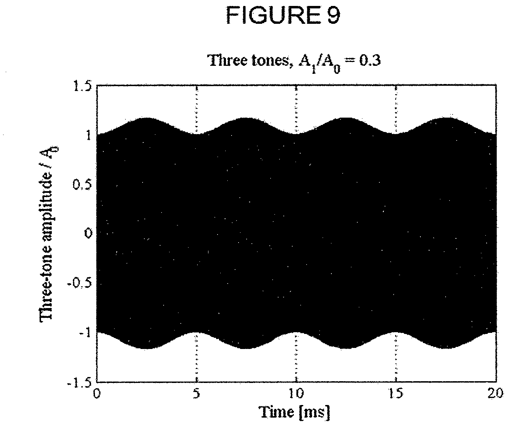

Fig. 9 shows a simple example of noise waveform after modulation. For example, if the noise has frequency f = 1 MHz, the modulation frequency is $\Delta f$ = 100 Hz, and the ratio between the first modulation harmonic A1 and the noise harmonic A0 is A1=A0 = 0:3, the resulting modulated waveform normalized to the fundamental noise harmonic A0 is shown in Fig. 9. Due to the high density of the lines in the figure, the high frequency oscillating signal looks like a single black strip between two enveloping curves of equation (2). The enveloping curves are important because they determine the output of a narrow band receiver centered at the frequency f0.

$$y = \pm\sqrt{1 + 2\frac{A_1^2}{A_0^2}\left[1 - \cos\left(4\pi\Delta f t\right)\right]} \tag{2}$$

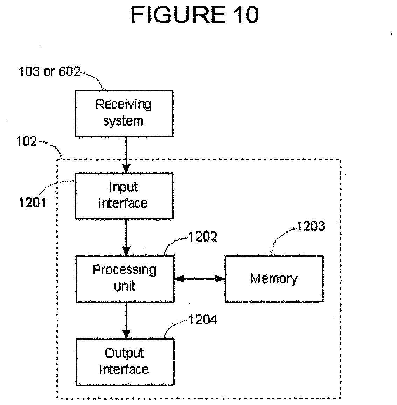

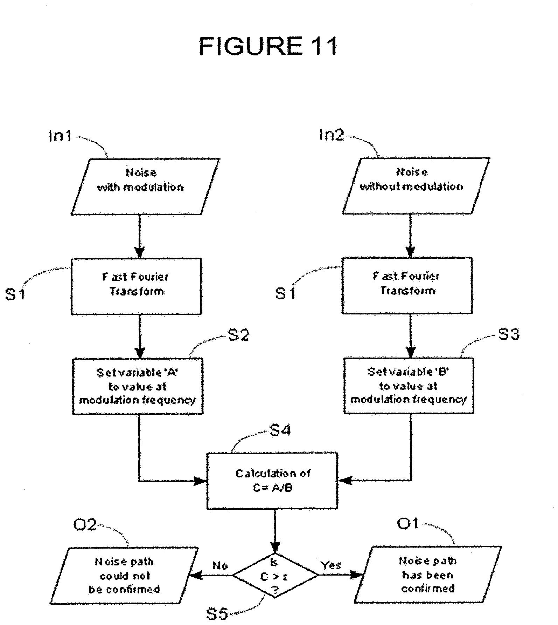

Fig. 10 shows a block diagram of the processing system 102 of Fig. 6 and comprises an input interface 1201, a processing unit 1202, a memory 1203 and an output interface 1204. For example, the processing unit 1202 executes algorithm explained by Fig. 11 based on a software code stored in the memory 1203. In this embodiment, the function by the software can be realized also with hardware such as FPGA (Field Programmable Gate Array) or an ASIC (Application Specific Integrated Circuit).

Fig. 11 shows the algorithm executed by the processing unit 1202. The received noise for the two cases with and without modulation, In1 and In2, respectively, is the input of the algorithm. The Fast Fourier Transform (FFT) is applied in the step S1 and the values at the modulation frequency are assigned to the variables A and B in the steps S2 and S3, respectively. The ratio C = A=B in the step S4 indicates how much the noise was affected by the modulation. If this ratio is larger than a preselected threshold in the step S5, the noise path has been confirmed (O1), otherwise (O2) it cannot be confirmed, either because it was not the noise path or because the modulation was not sufficient.

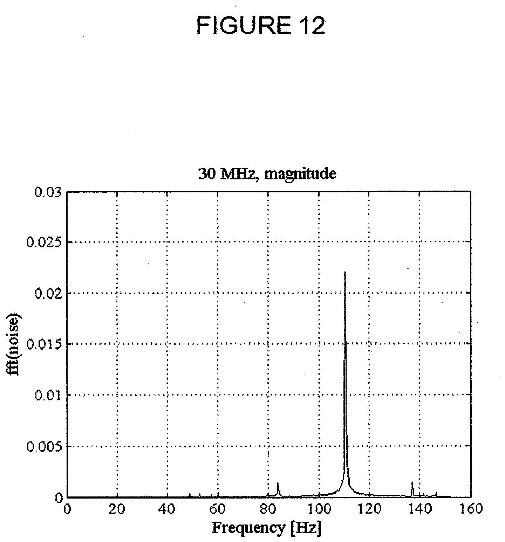

Fig. 12 shows an example of the FFT of a 30 MHz noise modulated with a square wave of frequency close to 115 Hz. Before applying the FFT the noise has been detected and down-converted by a narrow band receiver. The modulation frequency is clearly visible confirming the suspected noise path in this case.

[Embodiment 2]

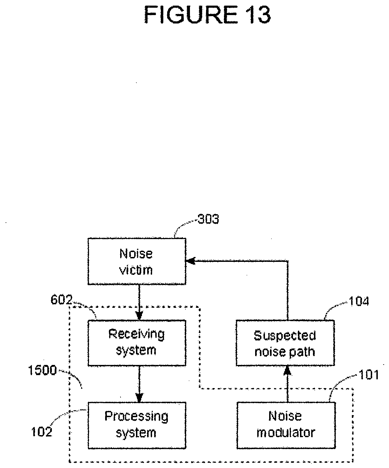

Fig. 13 shows the measurement system 1500 of the second embodiment. The measurement system 1500 comprises the modulator 101, the processing system 102 and a receiving system 602. This is required for those cases where a malfunction in the victim 303 has been detected but a suitable receiving system is not included in the victim. For example, if the victim is sensor, it can detect predetermined signal with the modulated noise by itself. But if the victim is train appliance such as light or air conditioner, suitable receiving system may be required.

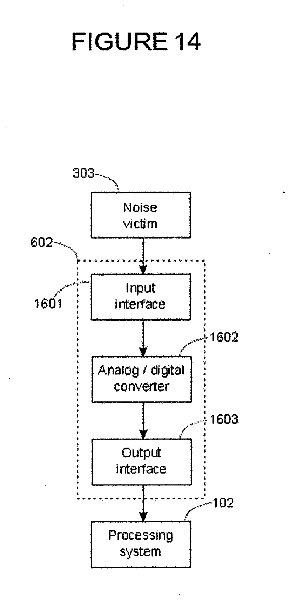

Fig. 14 shows a diagram of the main functional blocks of the receiving system 602 and comprises: an input interface 1601, an analog to digital converter 1602 and an output interface 1603. The input interface 1601 is coupled to the noise victim 303 and the output interface 1603 delivers the digitized data to the processing system 102.

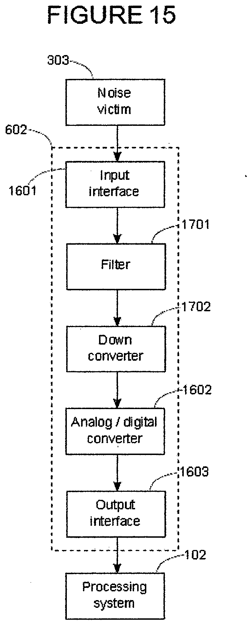

Fig. 15 shows a special case of the second embodiment and comprises also a filter 1701 and a down converter 1702.

[Embodiment 3]

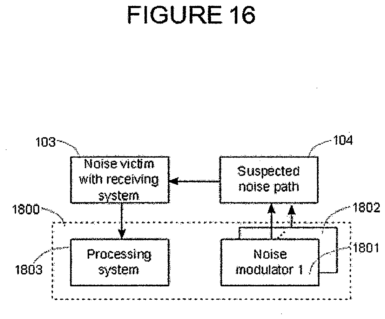

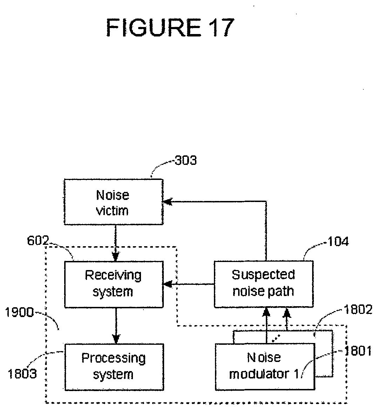

Figs. 16 and 17 show the two other embodiments 1800 and 1900, respectively. They can be obtained from the first and second embodiments by using multiple noise modulators 1801, 1802. Each modulator has a different time stamp, for example a different modulation frequency. The processing system 1803 is similar to the processing system 102, but the processing algorithm is executed for all the noise modulators 1801, 1802. In this way multiple suspected test path can be tested at the same time.

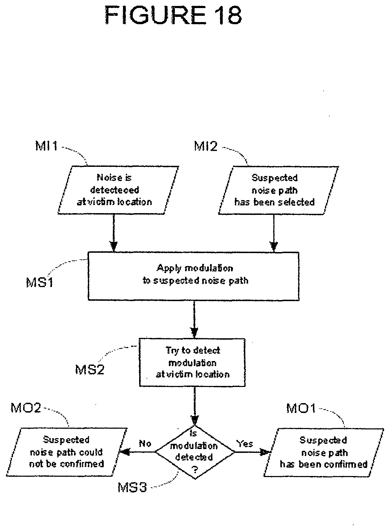

The present invention includes also the method for detecting the noise path shown in Fig. 18. The method can be applied after that some noise has been detected at the victim location MI1 and that at least one suspected noise path has been selected MI2. The step MS2 comprises the application of a modulation to the suspected noise path. In the step MS2, an attempt to detect the applied modulation at the victim location is made and in the step MS3 the results are evaluated. If the modulation is detected, the suspected noise path has been confirmed (M01). If the modulation cannot be detected, the noise path cannot be confirmed (MO2). The method can also be applied simultaneously to several noise paths. In this case a separate conclusion can be obtained for each noise path.

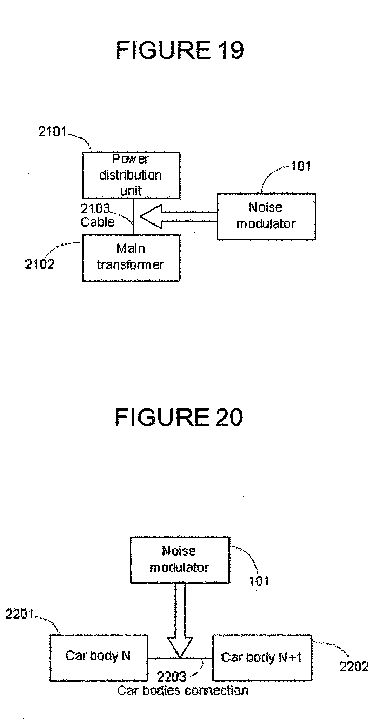

Further embodiments can be obtained by applying the above ones to a railway rolling stock, such as but not limited to the one shown in Fig. 1. Depending on the specific design, the noise victim (such as the ATC, a sensor, an antenna or a train appliance) may contain or not the required receiving system, which eventually must be included in the embodiment, similarly as above. Examples of noise paths where one or a plurality of noise modulators can be applied are described in the Figs. 19-23.

In Fig. 19, the noise modulator 101 applies a modulation to the cable 2103 between the main transformer 2102 and the power distribution unit 2101.

In Fig. 20, the noise modulator 101 applies a modulation to the connection 2203 between two consecutive car bodies, 2201 and 2202

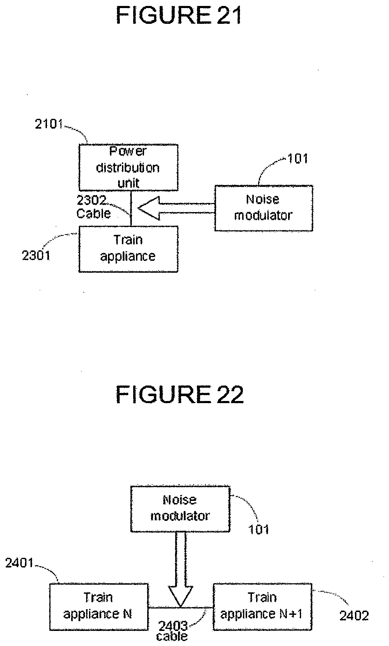

In Fig. 21, the noise modulator 101 applies a modulation to the cable 2302 between the power distribution unit 2101 and a train appliance 2301.

In Fig. 22, the noise modulator 101 applies a modulation to the cable 2403 between two train appliances, 2401 and 2402.

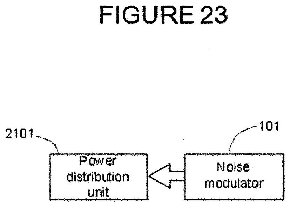

In Fig. 23, the noise modulator 101 applies a modulation to a cable inside the power distribution unit 2101.

As explained above, the embodiments includes measurement system and method to detect the electromagnetic noise path by modulating the noise on suspected noise paths. When the modulation is detected by a processing system connected to the noise victim, the noise path has been determined. More preferably, the system comprises a processing system and a noise modulator that is sufficiently coupled to the equipment under test to apply a modulation to the noise and sufficiently decoupled from the receiver that the radiated noise from the modulator cannot be detected by the receiver. In one embodiment the invention is specifically used to detect the noise path on railway rolling stocks.

The embodiments of the present invention reduces the time required to determine the noise path. By using different modulation schemes on different noise paths, several noise paths can be tested simultaneously. The modulator is not connected to the receiver and can be put at large distance from it, even inside enclosures.

These embodiments are explained in detail sufficiently for those skilled in the art to carry out the present invention. However, it is necessary to understand that other implementations and forms are also possible and changes of configurations and structures of various elements are possible without departing from the scope of the present invention as defined by the appended claims.

Therefore, the previous description should not be interpreted to be limited to the description.

[Industrial Applicability]

This invention can be applied to a measurement system and a method to individuate causes of electromagnetic compatibility for various electronic equipment.

[Reference signs List]

100: Measurement system
101: Noise modulator
102: Processing system
103: Noise victim with receiving system
104: Suspected noise path
301: Noise source 1
302: Noise source 2
303: Noise victim
304: Noise path
305: Connection between noise source and noise path
306: Connection between noise path and victim
401: Receiving and processing systems
601: Strong coupling
602: Receiving system
800: Current probe with modulated load
801: Coil
802: Magnetic core
803: Modulated load
901: Modulated load
902: Probe
1201: Input interface
1202: Processing unit
1203: Memory
1204: Output interface
1500: Noise modulator with receiving and processing systems
1601: Input interface
1602: Analog / digital converter
1603: Output interface
1701: Filter
1702: Down converter
1800: Noise detector system with multiple noise modulators
1801: Noise modulator 1
1802: Noise modulator N
1803: Processing system
1900: Noise detector system with receiver and multiple noise modulators
2101: Power distribution unit
2102: Main transformer

2103: Cable
2201: Car body N
2202: Car body N+1
2203: Car bodies connection
2301: Train appliance
2302: Cable
2401: Train appliance N
2402: Train appliance N+1
2403: Cable

**Claims**

1. An electromagnetic noise path detecting system comprising a processing system (102) which identifies whether a suspected noise path (104) is an actual noise path or not, **characterised in that**:

   the system further comprises a noise modulator (101) which is strongly enough coupled to the suspected noise path (104) that it applies a modulation to an electromagnetic noise when present, the electromagnetic coupling between said noise modulator and a noise victim of said electromagnetic noise being low enough that a radiated noise by said noise modulator cannot be detected at said noise victim;
   said processing system (102) determines an amount of said modulation on the electromagnetic noise detected at said noise victim to identify whether the suspected noise path is an actual noise path or not.

2. The electromagnetic noise path detecting system of claim 1, wherein:

   said noise modulator (101) comprises a current probe and a modulated load (800).

3. The electromagnetic noise path detecting system of claim 1, wherein:

   said noise victim detects said electromagnetic noise.

4. The electromagnetic noise path detecting system of claim 1, further comprising a receiving system (602), wherein:

   said receiving system (602) detects said electromagnetic noise at said noise victim (103) and sends it in digital form to said processing system, and
   said processing system (102) determines the amount of said modulation on the detected noise.

5. The electromagnetic noise path detecting system of claim 1, comprising a plurality of noise modulators (101) wherein:

   said noise modulators (101) are strongly enough coupled to the suspected noise paths (104) respectively, that they apply a modulation to the electromagnetic noise when present;
   each of said noise modulators (101) applies a different modulation to the electromagnetic noise on each suspected noise path (104);
   the electromagnetic coupling between said noise modulators (101) and the victim(103) of said electromagnetic noise is low enough that the radiated noise by said noise modulators cannot be detected at the noise victim;
   said processing system (102) determines the noise path based on the type and amount of said modulation on the noise detected at the victim (103) of said electromagnetic noise.

6. A rolling stock having the electromagnetic noise path detecting system according to claim 1, wherein:
   said noise modulator (101) is applied to one or a plurality of the following cables and connecting elements as said suspected noise path:

   a cable (2103) between a main transformer (2102) and a power distribution unit (2101),
   a connecting element (2203) between consecutive car bodies (2201, 2202),
   a cable (2302) between a power distribution unit (2101) and a train appliance (2301),
   a cable (2403) among train appliances (2401, 2402), and
   a cable inside a power distribution unit.

7. The rolling stock of claim 6, wherein:

   said electromagnetic noise has an influence on the noise victim, and
   said noise victim is one or a plurality of the following equipment:

   an automatic train control (ATC),
   a sensor,
   an antenna, and
   a train appliance.

8. The rolling stock of claim 6, comprising a plurality of noise modulators wherein:

   said noise modulators (101) are strongly enough coupled to the suspected noise paths (104) that they apply a modulation to the electromagnetic noise when present;
   each of said noise modulators (101) applies a different modulation to the electromagnetic noise on each suspected noise path (104);
   said processing system (102) determines the noise path based on the type and amount of said modulation on the noise detected at the victim of said electromagnetic noise.

9. The rolling stock of claim 6, wherein:

   said modulated electromagnetic noise is detected by the victim of said electromagnetic noise itself or a receiving system (602) separated from said victim, and
   the electromagnetic coupling between said noise modulators (101) and said victim or receiving system (602) is low enough that the radiated noise by said noise modulators cannot be detected by the victim or the receiving system.

10. A method to determine an electromagnetic noise path after an electromagnetic noise has been detected at a noise victim and one or a plurality of suspected noise paths have been selected, wherein:

    first step; a modulation is applied by a noise modulator (101) to said suspected noise path (104), said modulation applied by the noise modulator (101) being strongly enough coupled to said suspected noise path (104) that it applies a modulation to an electromagnetic noise when present, and the electromagnetic coupling between said noise modulator and the noise victim being low enough that a radiated noise by said noise modulator cannot be detected at said noise victim,
    second step; an attempt to detect said modulation at the location of said noise victim is made,
    third step; depending on an amount of a detected modulation, it is decided whether the suspect noise path (104) has been confirmed or not.

11. The method of claim 10, wherein:
    said noise modulator (101) comprises a current probe and a modulated load (800).

12. The method of claim 10, wherein:

    in the second step;
    said modulation is detected based on said electromagnetic noise received by at least one of a part of said noise victim and a receiving device (602) which is separated from said noise victim.

13. The method of claim 10, wherein:

    in the first step;
    each of a plurality of noise modulators (101) applies a different modulation to said electromagnetic noise on each suspected noise path (104);
    in the third step;
    an actual noise path is determined based on a type and the amount of said detected modulation.

14. The method of claim 10, wherein:

in the first step;
a modulation frequency of said modulation is smaller than that of said electromagnetic noise.

**Patentansprüche**

1.  Detektionssystem für einen elektromagnetischen Störpfad, umfassend ein Verarbeitungssystem (102), das identifiziert, ob ein vermuteter Störpfad (104) ein tatsächlicher Störpfad ist, **dadurch gekennzeichnet, dass**:

    das System weiters einen Störungsmodulator (101) umfasst, der stark genug mit dem vermuteten Störpfad (104) gekoppelt ist, dass er eine Modulation auf eine elektromagnetische Störung ausübt, wenn eine solche vorhanden ist, wobei die elektromagnetische Kopplung zwischen dem Störungsmodulator und einem Störopfer der elektromagnetischen Störung schwach genug ist, sodass eine von dem Störungsmodulator abgestrahlte Strahlung beim Störopfer nicht detektiert werden kann;
    wobei das Verarbeitungssystem (102) ein Ausmaß der Modulation an der elektromagnetischen Störung bestimmt, das beim Störopfer detektiert wurde, um zu identifizieren, ob der vermutete Störpfad ein tatsächlicher Störpfad ist.

2.  Detektionssystem für einen elektromagnetischen Störpfad nach Anspruch 1, wobei:
    der Störungsmodulator (101) eine Stromsonde und eine modulierte Last (800) umfasst.

3.  Detektionssystem für einen elektromagnetischen Störpfad nach Anspruch 1, wobei:
    das Störopfer die elektromagnetische Störung detektiert.

4.  Detektionssystem für einen elektromagnetischen Störpfad nach Anspruch 1, das weiters ein Empfangssystem (602) umfasst, wobei:

    das Empfangssystem (602) die elektromagnetische Störung beim Störopfer (103) detektiert und diese in digitaler Form an das Verarbeitungssystem sendet und
    das Verarbeitungssystem (102) das Ausmaß der Modulation an der detektierten Störung bestimmt.

5.  Detektionssystem für einen elektromagnetischen Störpfad nach Anspruch 1, das eine Vielzahl von Störungsmodulatoren (101) umfasst, wobei:

    die Störungsmodulatoren (101) jeweils stark genug mit den vermuteten Störpfaden (104) gekoppelt sind, dass sie eine Modulation auf die elektromagnetische Störung ausüben, wenn eine solche vorhanden ist,
    jeder der Störungsmodulatoren (101) eine andere Modulation auf die elektromagnetische Störung auf jedem vermuteten Störpfad (104) ausübt;
    die elektromagnetische Kopplung zwischen den Störungsmodulatoren (101) und dem Opfer (103) der elektromagnetischen Störung schwach genug ist, sodass eine von den Störungsmodulatoren abgestrahlte Störung beim Störopfer nicht detektiert werden kann;
    das Verarbeitungssystem (102) den Störpfad basierend auf der Art und dem Ausmaß der Modulation an der beim Opfer (103) der elektromagnetischen Störung detektierten Störung bestimmt.

6.  Schienenfahrzeug mit einem Detektionssystem für einen elektromagnetischen Störpfad nach Anspruch 1, wobei:

    der Störungsmodulator (101) auf eine oder eine Vielzahl der folgenden Kabel und Verbindungselemente als vermuteter Störpfad angewandt wird:

    ein Kabel (2103) zwischen einem Haupttransformator (2102) und einer Leistungsverteilungseinheit (2101),
    ein Verbindungselement (2203) zwischen aufeinanderfolgenden Wagenkörpern (2201, 2202),
    ein Kabel (2302) zwischen einer Leistungsverteilungseinheit (2101) und einer Eisenbahnzugvorrichtung (2301),
    ein Kabel (2403) zwischen Eisenbahnzugvorrichtungen (2401, 2402) und
    ein Kabel innerhalb einer Leistungsverteilungseinheit.

7.  Schienenfahrzeug nach Anspruch 6, wobei:

die elektromagnetische Störung einen Einfluss auf das Störopfer hat und
das Störopfer eine oder eine Vielzahl der folgenden Vorrichtungen ist:

eine automatische Zugsteuerung (ATC),
ein Sensor,
eine Antenne und
eine Eisenbahnzugvorrichtung.

**8.** Schienenfahrzeug nach Anspruch 6, das eine Vielzahl von Störungsmodulatoren umfasst, wobei:

die Störungsmodulatoren (101) stark genug mit den vermuteten Störpfaden (104) gekoppelt sind, dass sie eine Modulation auf die elektromagnetische Störung ausüben, wenn eine solche vorhanden ist;
jeder der Störungsmodulatoren (101) eine unterschiedliche Modulation auf die elektromagnetische Störung auf jedem vermuteten Störpfad (104) ausübt;
das Verarbeitungssystem (102) den Störpfad basierend auf der Art und dem Ausmaß der Modulation an der beim Opfer der elektromagnetischen Störung detektierten Störung bestimmt.

**9.** Schienenfahrzeug nach Anspruch 6, wobei:

die modulierte elektromagnetische Störung vom Opfer der elektromagnetischen Störung selbst oder von einem vom Opfer getrennten Empfangssystem (602) detektiert wird und
die elektromagnetische Kopplung zwischen den Störungsmodulatoren (101) und dem Opfer oder Empfangssystem (602) schwach genug ist, sodass die von den Störungsmodulatoren abgestrahlte Störung vom Opfer oder Empfangssystem nicht detektiert werden kann.

**10.** Verfahren zum Bestimmen eines elektromagnetischen Störpfads, nachdem eine elektromagnetische Störung bei einem Störopfer detektiert wurde und ein oder eine Vielzahl von Störpfaden ausgewählt wurden, wobei:

erster Schritt: eine Modulation von einem Störungsmodulator (101) auf den vermuteten Störpfad (104) angelegt wird, wobei die vom Störungsmodulator (101) angelegte Modulation stark genug mit dem vermuteten Störpfad (104) gekoppelt ist, dass sie eine Modulation auf eine elektromagnetische Störung ausübt, wenn eine solche vorhanden ist, und die elektromagnetische Kopplung zwischen dem Störungsmodulator und dem Störopfer schwach genug ist, dass eine von dem Störungsmodulator abgestrahlte Störung an dem Störopfer nicht detektiert werden kann,
zweiter Schritt: ein Versuch, die Modulation an der Position des Störopfers nachzuweisen, wird gemacht,
dritter Schritt: abhängig vom Ausmaß einer detektierten Modulation wird entschieden, ob der vermutete Störpfad (104) bestätigt wurde oder nicht.

**11.** Verfahren nach Anspruch 10, wobei:
der Störungsmodulator (101) eine Stromsonde und eine modulierte Last (800) umfasst.

**12.** Verfahren nach Anspruch 10, wobei:
im zweiten Schritt:
die Modulation basierend auf der elektromagnetischen Störung detektiert wird, die von zumindest einem Teil des Störopfers und einer von dem Störopfer getrennten Empfangsvorrichtung (602) empfangen wird.

**13.** Verfahren nach Anspruch 10, wobei:

im ersten Schritt:
jeder einer Vielzahl von Störungsmodulatoren (101) eine unterschiedliche Modulation auf die elektromagnetische Störung auf jedem vermuteten Störpfad (104) ausübt,
im dritten Schritt:
ein tatsächlicher Störpfad basierend auf einer Art und dem Ausmaß der detektierten Modulation bestimmt wird.

**14.** Verfahren nach Anspruch 10, wobei:
im ersten Schritt:
eine Modulationsfrequenz der Modulation niedriger ist als die der elektromagnetischen Störung.

**Revendications**

1. Système de détection de trajet de bruit électromagnétique comprenant un système de traitement (102) qui identifie si un trajet de bruit suspecté (104) est un trajet de bruit réel ou non, **caractérisé en ce que** :

   le système comprend en outre un modulateur de bruit (101) qui est couplé de manière suffisamment forte au trajet de bruit suspecté (104) de sorte qu'il applique une modulation à un bruit électromagnétique lorsqu'il est présent, le couplage électromagnétique entre ledit modulateur de bruit et une victime de bruit dudit bruit électromagnétique étant suffisamment faible pour qu'un bruit rayonné par ledit modulateur de bruit ne puisse pas être détecté au niveau de ladite victime de bruit ;
   ledit système de traitement (102) détermine une quantité de ladite modulation sur le bruit électromagnétique détecté au niveau de ladite victime de bruit pour identifier si le trajet de bruit suspecté est un trajet de bruit réel ou non.

2. Système de détection de trajet de bruit électromagnétique selon la revendication 1, dans lequel :
   ledit modulateur de bruit (101) comprend une sonde de courant et une charge modulée (800).

3. Système de détection de trajet de bruit électromagnétique selon la revendication 1, dans lequel :
   ladite victime de bruit détecte ledit bruit électromagnétique.

4. Système de détection de trajet de bruit électromagnétique selon la revendication 1, comprenant en outre un système de réception (602), dans lequel :

   ledit système de réception (602) détecte ledit bruit électromagnétique au niveau de ladite victime de bruit (103) et l'envoie sous forme numérique audit système de traitement, et
   ledit système de traitement (102) détermine la quantité de ladite modulation sur le bruit détecté.

5. Système de détection de trajet de bruit électromagnétique selon la revendication 1, comprenant une pluralité de modulateurs de bruit (101), dans lequel :

   lesdits modulateurs de bruit (101) sont couplés de manière suffisamment forte aux trajets de bruit suspectés (104), respectivement, de sorte qu'ils appliquent une modulation au bruit électromagnétique lorsqu'il est présent ;
   chacun desdits modulateurs de bruit (101) applique une modulation différente au bruit électromagnétique sur chaque trajet de bruit suspecté (104) ;
   le couplage électromagnétique entre lesdits modulateurs de bruit (101) et la victime (103) dudit bruit électromagnétique est suffisamment faible pour que le bruit rayonné par lesdits modulateurs de bruit ne puisse pas être détecté au niveau de la victime de bruit ;
   ledit système de traitement (102) détermine le trajet de bruit sur la base du type et de la quantité de ladite modulation sur le bruit détecté au niveau de la victime (103) dudit bruit électromagnétique.

6. Matériel roulant présentant le système de détection de trajet de bruit électromagnétique selon la revendication 1, dans lequel :

   ledit modulateur de bruit (101) est appliqué à un ou plusieurs des câbles et éléments de connexion suivants en tant que trajet de bruit suspecté :

   un câble (2103) entre un transformateur principal (2102) et une unité de distribution d'énergie (2101),
   un élément de connexion (2203) entre des carrosseries de voiture consécutives (2201, 2202),
   un câble (2302) entre une unité de distribution d'énergie (2101) et un appareil de train (2301),
   un câble (2403) parmi des appareils de train (2401, 2402), et
   un câble à l'intérieur d'une unité de distribution d'énergie.

7. Matériel roulant selon la revendication 6, dans lequel :

   ledit bruit électromagnétique a une influence sur la victime de bruit, et
   ladite victime de bruit est un ou plusieurs des équipements suivants :

   une commande automatique de train (ATC),

un capteur,
une antenne, et
un appareil de train.

8. Matériel roulant selon la revendication 6, comprenant une pluralité de modulateurs de bruit dans lequel :

lesdits modulateurs de bruit (101) sont couplés de manière suffisamment forte aux trajets de bruit suspectés (104) de sorte qu'ils appliquent une modulation au bruit électromagnétique lorsqu'il est présent ;
chacun desdits modulateurs de bruit (101) applique une modulation différente au bruit électromagnétique sur chaque trajet de bruit suspecté (104) ;
ledit système de traitement (102) détermine le trajet de bruit sur la base du type et de la quantité de ladite modulation sur le bruit détecté au niveau de la victime dudit bruit électromagnétique.

9. Matériel roulant selon la revendication 6, dans lequel :

ledit bruit électromagnétique modulé est détecté par la victime dudit bruit électromagnétique elle-même ou par un système de réception (602) séparé de ladite victime, et
le couplage électromagnétique entre lesdits modulateurs de bruit (101) et ladite victime ou ledit système de réception (602) est suffisamment faible pour que le bruit rayonné par lesdits modulateurs de bruit ne puisse pas être détecté par la victime ou le système de réception.

10. Procédé pour déterminer un trajet de bruit électromagnétique après qu'un bruit électromagnétique a été détecté au niveau d'une victime de bruit et qu'un ou plusieurs trajets de bruit suspectés ont été sélectionnés, dans lequel :

première étape ; une modulation est appliquée par un modulateur de bruit (101) audit trajet de bruit suspecté (104), ladite modulation appliquée par le modulateur de bruit (101) étant couplée de manière suffisamment forte audit trajet de bruit suspecté (104) de sorte qu'elle applique une modulation à un bruit électromagnétique lorsqu'il est présent, et le couplage électromagnétique entre ledit modulateur de bruit et la victime de bruit étant suffisamment faible pour qu'un bruit rayonné par ledit modulateur de bruit ne puisse pas être détecté au niveau de ladite victime de bruit,
deuxième étape ; une tentative de détection de ladite modulation à l'emplacement de ladite victime de bruit est effectuée,
troisième étape ; en fonction d'une quantité d'une modulation détectée, il est décidé si le trajet de bruit suspecté (104) a été confirmé ou non.

11. Procédé selon la revendication 10, dans lequel :
ledit modulateur de bruit (101) comprend une sonde de courant et une charge modulée (800).

12. Procédé selon la revendication 10, dans lequel :

dans la deuxième étape ;
ladite modulation est détectée sur la base dudit bruit électromagnétique reçu par au moins une parmi une partie de ladite victime de bruit et un dispositif de réception (602) qui est séparé de ladite victime de bruit.

13. Procédé selon la revendication 10, dans lequel :

dans la première étape ;
chacun d'une pluralité de modulateurs de bruit (101) applique une modulation différente au bruit électromagnétique sur chaque trajet de bruit suspecté (104) ;
dans la troisième étape ;
un trajet de bruit réel est déterminé sur la base d'un type et de la quantité de ladite modulation détectée.

14. Procédé selon la revendication 10, dans lequel :

dans la première étape ;
une fréquence de modulation de ladite modulation est inférieure à celle dudit bruit électromagnétique.

# FIGURE 1

# FIGURE 2

# FIGURE 3

# FIGURE 4

# FIGURE 5

800 801 802 803

# FIGURE 6

# FIGURE 7

# FIGURE 8

# FIGURE 9

Three tones, $A_1/A_0 = 0.3$

# FIGURE 10

103 or 602

```
Receiving
system
```

102

1201

```
Input
interface
```

1202

```
Processing
unit
```

1203

```
Memory
```

1204

```
Output
interface
```

# FIGURE 11

# FIGURE 12

30 MHz, magnitude

# FIGURE 13

# FIGURE 14

# FIGURE 15

303 ─

```
┌─────────────┐
│    Noise    │
│   victim    │
└─────────────┘
```

602 ─

1601 ─

```
┌─────────────┐
│    Input    │
│  interface  │
└─────────────┘
```

─ 1701

```
┌─────────────┐
│   Filter    │
└─────────────┘
```

─ 1702

```
┌─────────────┐
│    Down     │
│  converter  │
└─────────────┘
```

─ 1602

```
┌──────────────────┐
│  Analog / digital │
│    converter      │
└──────────────────┘
```

─ 1603

```
┌─────────────┐
│   Output    │
│  interface  │
└─────────────┘
```

─ 102

```
┌─────────────┐
│ Processing  │
│   system    │
└─────────────┘
```

# FIGURE 16

# FIGURE 17

# FIGURE 18

MI1

MI2

Noise is
detecteced
at victim location

Suspected
noise path
has been selected

MS1

Apply modulation
to suspected noise path

MS2

Try to detect
modulation
at victim location

MO2

MO1

Suspected
noise path could
not be confirmed

No — Is
modulation
detected
? — Yes

Suspected
noise path
has been confirmed

MS3

# FIGURE 19

2101

Power
distribution
unit

101

2103
Cable

Noise
modulator

2102

Main
transformer

# FIGURE 20

Noise
modulator

101

2201

Car body N

Car body N+1

2202

2203

Car bodies connection

# FIGURE 21

2101 —

Power
distribution
unit

~101

2302.
Cable

Noise
modulator

2301

Train
appliance

# FIGURE 22

Noise
modulator

101

2401 —

Train
appliance N

2403
cable

Train
appliance N+1

2402

# FIGURE 23

2101

Power distribution unit

101

Noise modulator

**EP 3 455 639 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H06288873 A
- US 20150028888 A
- US 20110135027 A

**Non-patent literature cited in the description**

- Engineering Applications of the Modulated Scatterer technique. **J.J.-C. BOLOMEY ; F.E. GARDIOL.** Artech House. 2001
- **R.-R. LAO et al.** High-Sensitivity Optically Modulated Scatterer for Electromagnetic-Field Measurement. *IEEE Transactions On Instrumentation and Measurement,* April 2007, vol. 56 (2), 486-490